# EUROPEAN PATENT APPLICATION

(11) **EP 2 832 498 A1**
(43) Date of publication of application: **04.02.2015**
(21) Application number: 13768331.4
(22) Date of filing: 21.03.2013
(51) Int. Cl.: B24B 37/28, H01L 21/304

(54) **MATERIAL FOR HOLDING ITEM TO BE POLISHED, AND LAMINATE PLATE USING SAME**

(30) Priority: 30.03.2012 JP 2012078719; 10.12.2012 JP 2012269289
(71) Applicant: Sumitomo Bakelite Co., Ltd., Shinagawa-ku Tokyo 140-0002 (JP)
(72) Inventor: TAKETANI, Mitsuo, Tokyo 140-0002 (JP); MARUYAMA, Toyotaro, Tokyo 140-0002 (JP)
(74) Representative: Ter Meer Steinmeister & Partner
(86) International application number: PCT/JP2013/058034
(87) International publication number: WO 2013/146517

(57) **Abstract**

The invention provides a holder for a polished work in which the warpage suppression or plate thickness accuracy of the holder for a polished work is improved, the generation of scratches in a polished work is suppressed so as to improve the abrasion resistance, and furthermore, economic advantages are provided. The holder for a polished work of the invention includes a first resin layer produced by impregnating a first resin composition into a first fiber base material, and heating and pressurizing the first fiber base material as an outermost layer, the first fiber base material is a glass fiber base material, and a structure derived from a resin having a novolac skeleton is included in a proportion of 50 mass% or more in the first resin layer excluding the first fiber base material.

## Description

### Technical Field

The present invention relates to a holder for a polished work, and a laminate plate used for the same.

Priority is claimed on Japanese Patent Application No. 2012-078719, filed March 30, 2012, and Japanese Patent Application No. 2012-269289, filed December 10, 2012, the contents of which are incorporated herein by reference.

### Background Art

As a laminate plate used for a holder for a polished work when polishing the polished work such as a silicon wafer or a hard disk, a laminate plate produced by laminating a predetermined number of sheets of a prepreg, which is obtained by impregnating and drying a thermosetting resin such as an epoxy resin in a fiber base material, and molding the sheets into a single body through heating and pressurization is used.

The laminate plate is shaped into a holder for a polished work in the following manner. A circular plate having predetermined dimensions is cut out from a laminate plate having a fixed size, and one or multiple circular holes are opened in the laminate plate. In addition, teeth of a gear are formed around the circular plate. When polishing is carried out using a holder for a polished work as manufactured in the above-described manner, the holder is set in a polisher, and a polished work is held in the circular holes. Teeth of a driving gear are engaged with the teeth around the holder, and the holder is driven. Accordingly, the polished work held in the circular holes is also driven, and the surface of the polished work is polished by a polishing material that is in contact with the surface.

The holder for a polished work is required to have characteristics of abrasion resistance, plate thickness accuracy, warpage suppression characteristics, and dimensional stability. In addition, along with the recent requirement for better qualities or performance of a polished work, there has been a demand for a holder for a polished work capable of suppressing the generation of scratches (polishing flaws) in a polished work.

For the improvement of the holder for a polished work, an aramid-based fiber (for example, refer to Patent Document 1) has been studied as a material that forms the holder for a polished work which does not allow the generation of scratches in a polished work, but there has been a demand for an additional improvement of the abrasion resistance of a holder for a polished work, the suppression of warpage, or an improvement of the plate thickness accuracy in a holder for a polished work in response to the thickness reduction of a substrate that is a polished work.

To improve the above-described characteristics, a holder for a polished work obtained by using prepreg produced by impregnating a composition of a thermosetting resin such as an epoxy resin into an organic fiber base material such as an aramid fiber, a PBO fiber, a wholly-aromatic polyester fiber, or a high-strength polyethylene fiber as a surface layer, using prepreg produced by impregnating a composition of a thermosetting resin such as an epoxy resin into a glass fiber base material as an intermediate layer, and laminating, heating, and pressurizing the prepreg sheets (for example, refer to Patent Document 2) and the like have been studied. However, there was a problem of distortion caused by the difference in the linear expansion coefficient between the organic fiber base material used as the surface layer and the glass fiber material used as the intermediate layer, and there was room for improvement in terms of the suppression of warpage or the improvement of the plate thickness accuracy in a holder for a polished work in response to the thickness reduction of a substrate. In addition, since the organic fiber such as an aramid fiber, a PBO fiber, a wholly-aromatic polyester fiber, or a high-strength polyethylene fiber is more expensive compared with a glass fiber, in consideration of economic efficiency, there has been a desire to achieve both the suppression of warpage and an improvement of the plate thickness accuracy in a holder for a polished work, in addition to the suppression of the generation of scratches in a polished work without using an organic fiber.

### Citation List

### Patent Document

[Patent Document 1] Japanese Unexamined Patent Application, First Publication No. H11-309667
[Patent Document 2] Japanese Unexamined Patent Application, First Publication No. 2009-61531

### Summary of Invention

### Technical Problem

The invention has been made in consideration of the above-described circumstances, and an object of the invention is to provide a holder for a polished work in which the same glass fiber base material as a fiber base material used for an intermediate layer is used as a fiber base material used for a surface layer, thereby improving the warpage suppression or plate thickness accuracy of the holder for a polished work in response to the thickness reduction of a substrate, suppressing the generation of scratches in a polished work so as to improve the abrasion resistance, and furthermore, providing economic advantages.

### Solution to Problem

The invention can be described as below.

A holder for a polished work of the invention is a holder for a polished work including a first resin layer produced by impregnating a first resin composition into a first fiber base material, and heating and pressurizing the first fiber base material as an outermost layer, in which the first fiber base material is a glass fiber base material, and a structure derived from a resin having a novolac skeleton is included in a proportion of 50 mass% or more in the first resin layer excluding the first fiber base material.

In the holder for a polished work of the invention, the first fiber base material may be included in a proportion in a range of 25 mass% to 60 mass% in the first resin layer.

In the holder for a polished work of the invention, the first fiber base material may be made of a glass fiber fabric having a weight per area in a range of 30 g/m² to 150 g/m².

In the holder for a polished work of the invention, the first resin composition may contain one or more resins selected from a novolac-type epoxy resin and a novolac-type phenol resin.

In the holder for a polished work of the invention, the first resin composition may contain the novolac-type epoxy resin in a proportion in a range of 40 parts by mass to 80 parts by mass in 100 parts by mass of the composition.

In the holder for a polished work of the invention, the first resin composition may contain the novolac-type phenol resin in a proportion in a range of 20 parts by mass to 40 parts by mass in 100 parts by mass of the composition.

In the holder for a polished work of the invention, the first resin composition may further contain a bisphenol A-type epoxy resin in a proportion in a range of 5 parts by mass to 40 parts by mass in 100 parts by mass of the composition.

The holder for a polished work of the invention includes one or more second resin layers produced by impregnating a second resin composition into a second fiber base material, and heating and pressurizing the second fiber base material as an inside layer, and the second fiber base material is a glass fiber base material.

In the holder for a polished work of the invention, the second fiber base material may be made of a glass fiber fabric having a weight per area in a range of 100 g/m² to 220 g/m².

A laminate plate of the invention is used for the above-described holder for a polished work.

### Advantageous Effects of Invention

According to the invention, it is possible to provide a holder for a polished work in which the warpage suppression or plate thickness accuracy of the holder for a polished work is improved in response to the thickness reduction of a substrate, the generation of scratches in a polished work is suppressed so as to improve the abrasion resistance, and furthermore, economic advantages are provided.

### Brief Description of Drawings

FIG. 1 is a plain view showing an embodiment of a holder for a polished work of the invention.
FIG. 2 is a cross-sectional view showing an embodiment of a laminate plate used in the holder for a polished work of the invention.

### Description of Embodiments

Hereinafter, embodiments of the invention will be described using the accompanying drawings. In all the drawings, the same components will be given the same reference sign, and will not be described as appropriate.

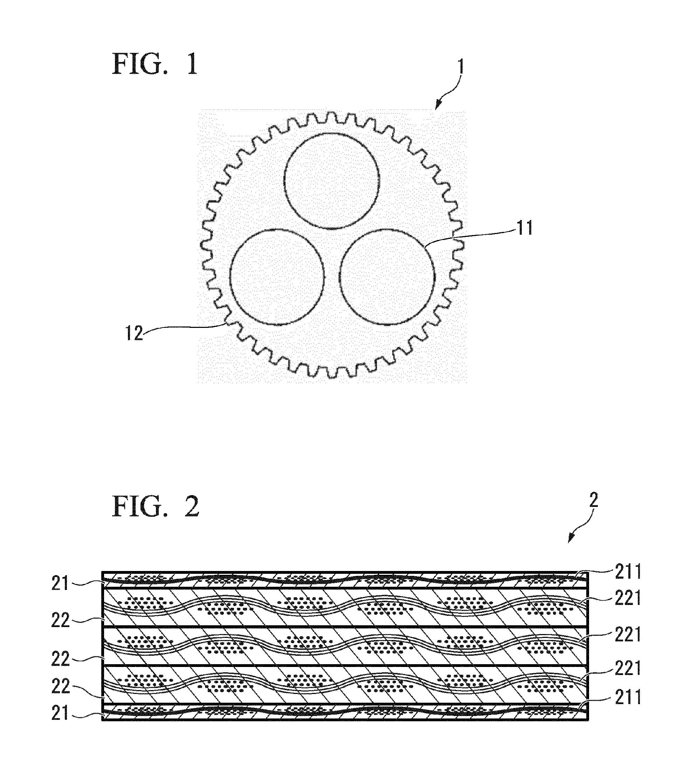

FIG. 1 shows a plain view showing an embodiment of a holder for a polished work of the invention, and FIG. 2 shows a cross-sectional view showing an embodiment of a laminate plate used in the holder for a polished work of the invention.

The holder 1 for a polished work of the invention is, for example, a flat plate having a shape as illustrated in the plain view of FIG. 1, and this holder 1 for a polished work can be produced by, for example, cutting out a circular plate having predetermined dimensions from a laminate plate 2 having a fixed size as shown in FIG. 2, opening one or multiple circular holes 11 in the cut-out circular plate, and forming teeth of a gear 12 around the circular plate. A polished work can be polished using the holder 1 for a polished work produced in the above-described manner by setting the holder 1 for a polished work in a polisher, holding a polished work in the circular holes 11 in the holder 1 for a polished work, engaging teeth of a driving gear with the teeth of the gear 12 around the holder 1 for a polished work, and driving the holder 1 for a polished work and the polished work held in the circular holes 11 in the holder 1 for a polished work.

The holder 1 for a polished work of the invention and the laminate plate 2 used in the same are the holder 1 for a polished work including a first resin layer 21 produced by impregnating a first resin composition into a first fiber base material 211, and heating and pressurizing the first fiber base material as an outermost layer, in which the first fiber base material is a glass fiber base material, and a structure derived from a resin having a novolac skeleton is included in a proportion of 50 mass% or more in the first resin layer excluding the first fiber base material. Then, it is possible to obtain a holder for a polished work in which the warpage suppression or plate thickness accuracy of the holder for a polished work is improved in response to the thickness reduction of a substrate, the generation of scratches in a polished work is suppressed so as to improve the abrasion resistance, and furthermore, economic advantages are provided. The proportion of the structure derived from a resin having a novolac skeleton in the first resin layer excluding the first fiber base material is more preferably 60 mass% or more, and still more preferably 70 mass% or more. Then, the above-described effects are more significantly exhibited. Examples of the resin having a novolac skeleton include novolac-type epoxy resins such as a phenol novolac-type epoxy resin and a cresol novolac-type epoxy resin; novolac-type phenol resins such as a phenol novolac resin, a cresol novolac resin, triazine novolac resin, a cashew-denatured novolac resin, a melamine resin, a phenoxy-denatured novolac resin, xylene-denatured novolac resin, and mesitylene-denatured novolac resin; and the like. In addition, the fact that the structure derived from a resin having a novolac skeleton is included in a proportion of a predetermined mass% in the first resin layer excluding the first fiber base material means that a predetermined amount of the above-described resin having a novolac skeleton is included as the first resin composition in the first resin layer, whereby the abrasion resistance is improved in the first resin layer excluding the first fiber base material.

First, the first resin layer 21 configuring the outermost layer in the holder 1 for a polished work of the invention and a laminate plate 2 used in the same will be described in detail. The first resin layer 21 is produced by impregnating the first resin composition into the first fiber base material 211, and heating and pressurizing the first fiber base material.

As the first fiber base material 211 used in the first resin layer 21, a glass fiber fabric having a weight per area in a range of 30 g/m² to 150 g/m² is preferably used, and a glass fiber fabric having a weight per area in a range of 48 g/m² to 105 g/m² is more preferably used. Then, the generation of scratches in a polished work is suppressed, and it is possible to obtain an effect that improves the abrasion resistance. In addition, as the first fiber base material 211, a glass fiber fabric made of 100 to 300 filaments is preferably used, and a glass fiber fabric made of 150 to 250 filaments is more preferably used. Then, the generation of scratches in a polished work is suppressed, and it is possible to obtain an effect that improves the abrasion resistance. Furthermore, as the first fiber base material 211, a glass fiber fabric having a thickness in a range of 50 µm to 150 µm is preferably used, and a glass fiber fabric having a thickness in a range of 80 µm to 120 µm is more preferably used. Then, the generation of scratches in a polished work is suppressed, and it is possible to obtain an effect that improves the abrasion resistance. Examples of the above-described glass fiber fabric include glass fiber fabrics having an IPC specification of #1501, #1504, #2117, #2116, #1116, #3313, #2319, #1280, #1080, #1078, #1067, or #106. These glass fiber fabrics may have been subjected to an opening process or a flattening process.

A glass component configuring the first fiber base material 211 used in the first resin layer 21 is not particularly limited, and examples thereof include E glass, NE glass, C glass, D glass, S glass, T glass, Q glass, AR glass, and the like. Among the above-described glasses, T glass is preferable from the viewpoint of abrasion resistance, and E glass is preferable from the viewpoint of productivity and economic efficiency.

The holder 1 for a polished work of the invention includes the first fiber base material 211 in the first resin layer 21 preferably in a proportion in a range of 25 mass% to 60 mass%, and more preferably in a proportion in a range of 45 mass% to 60 mass%. Then, it is possible to enhance the effect that improves the warpage suppression or plate thickness accuracy of the holder for a polished work in response to the thickness reduction of a substrate. In addition, within the above-described range, it is possible to obtain the effect that suppresses the generation of scratches in a polished work. From the viewpoint of obtaining an effect that suppresses noise in a polisher, the proportion of the first fiber base material 211 in the first resin layer 21 is preferably in a range of 25 mass% to 50 mass%, and more preferably in a range of 35 mass% to 50 mass%.

The first resin composition impregnated into the first fiber base material 211 is preferably a thermosetting resin such as a urea resin, a melamine resin, a phenol resin, an epoxy resin, an unsaturated polyester resin, an alkyd resin, or a urethane resin, and is particularly preferably an epoxy resin.

The epoxy resin simply needs to have two or more epoxy groups in the molecule, and examples thereof include bisphenol-type epoxy resins such as a bisphenol A-type epoxy resin, a bisphenol F-type epoxy resin, a bisphenol E-type epoxy resin, a bisphenol S-type epoxy resin, a bisphenol Z-type epoxy resin, a bisphenol P-type epoxy resin, and a bisphenol M-type epoxy resin; novolac-type epoxy resins such as a phenol novolac-type epoxy resin and a cresol novolac-type epoxy resin; aryl alkylene-type epoxy resins such as a biphenyl-type epoxy resin, a xylylene-type epoxy resin, and a biphenyl aralkyl-type epoxy resin; a naphthalene-type epoxy resin, an anthracene-type epoxy resin, a phenoxy-type epoxy resin, a dicyclopentadiene-type epoxy resin, a norbornene-type epoxy resin, an adamantane-type epoxy resin, a fluorene-type epoxy resin, and the like.

As the epoxy resin, one of the above-described epoxy resins can be singly used, two or more epoxy resins having different weight-average molecular weights can be jointly used, or one or more epoxy resins and a prepolymer thereof can be jointly used. From the viewpoint of abrasion resistance, a novolac-type epoxy resin is more preferable, and a cresol novolac-type epoxy resin is particularly preferable. The amount of the novolac-type epoxy resin is not particularly limited; however, in 100 parts by mass of the first resin composition, the novolac-type epoxy resin is more preferably included in a proportion in a range of 40 parts by mass to 80 parts by mass, and is particularly preferably included in a proportion in a range of 40 parts by mass to 60 parts by mass. Then, it is possible to increase the surface hardness of the first resin layer 21, and to obtain an effect that improves the abrasion resistance. In addition, since the skin layer of the resin abrades slowly, it is possible to extend the time taken for the glass fiber to be exposed on a polished surface, and thus it is possible to obtain an effect that suppresses the generation of scratches in a polished work.

In addition, from the viewpoint of the warpage suppression of the laminate plate, a bisphenol-type epoxy resin is more preferable, and a bisphenol A-type epoxy resin is particularly preferable. The amount of the bisphenol A-type epoxy resin is not particularly limited; however, in 100 parts by mass of the first resin composition, the bisphenol A-type epoxy resin is more preferably included in a proportion in a range of 5 parts by mass to 40 parts by mass, and is particularly preferably included in a proportion in a range of 10 parts by mass to 30 parts by mass. Then, the warpage of the holder for a polished work is suppressed, and it is possible to improve the flatness of a polished work.

In a case in which the epoxy resin is used as the first resin composition impregnated into the first fiber base material 211, the epoxy resin can contain an ordinary curing agent or curing accelerator for the epoxy resin which is generally used. A well-known curing agent can be used as an available curing agent, and examples thereof include novolac-type phenol resins such as a phenol novolac resin and a cresol novolac resin; polyvalent phenols such as 1,1,1-tris hydroxyphenyl ethane; amine-based curing agents such as aromatic amines and aliphatic amines; acid anhydrides; dicyandiamide; hydrazide compounds; and the like.

As the curing agent, one of the above-described curing agents can be singly used, or two or more curing agents can be jointly used. From the viewpoint of abrasion resistance, a novolac-type phenol resin is more preferable, and a phenol novolac resin is particularly preferable. The amount of the novolac-type phenol resin is not particularly limited; however, in 100 parts by mass of the first resin composition, the novolac-type phenol resin is more preferably included in a proportion in a range of 20 parts by mass to 40 parts by mass, and is particularly preferably included in a proportion in a range of 25 parts by mass to 35 parts by mass. Then, it is possible to increase the surface hardness of the first resin layer 21, and to obtain an effect that improves the abrasion resistance. In addition, since the skin layer of the resin abrades slowly, it is possible to extend the time taken for the glass fiber to be exposed on a polished surface, and thus it is possible to obtain an effect that suppresses the generation of scratches in a polished work.

The first resin composition impregnated into the first fiber base material 211 may contain an inorganic filler. An inorganic filler that can be used is not particularly limited, and examples thereof include alumina, kaolin clay, silica, titanium oxide, magnesium hydroxide, aluminum hydroxide, magnesium oxide, calcium carbonate, magnesium carbonate, talc, mica, and the like. These inorganic fillers may be singly used, or two or more inorganic fillers may be jointly used. The use of the inorganic filler enables the improvement of the strength of the first resin layer. In addition, the use of the inorganic filler enables a decrease in the linear expansion coefficient of the first resin layer, and thus it becomes possible to bring the linear expansion coefficient of the first resin layer and the linear expansion coefficient of a second resin layer that will be described below closer by appropriately adjusting the amount of the inorganic filler incorporated, and it becomes possible to improve the warpage suppression or plate thickness accuracy of the holder for a polished work in response to the thickness reduction of a substrate.

Next, a second resin layer 22 configuring an inside layer in the holder 1 for a polished work of the invention and a laminate plate 2 used in the same will be described in detail. The second resin layer 22 is produced by impregnating a second resin composition into a second fiber base material 221, and heating and pressurizing the second fiber base material, and the second fiber base material is a glass fiber base material.

As the second fiber base material 221 used in the second resin layer 22, a glass fiber fabric having a weight per area in a range of 100 g/m² to 220 g/m² is preferably used, and a glass fiber fabric having a weight per area in a range of 140 g/m² to 220 g/m² is more preferably used. Then, it is possible to obtain an effect that improves the warpage suppression or plate thickness accuracy of the holder for a polished work in response to the thickness reduction of a substrate. In addition, as the second fiber base material 221, a glass fiber fabric made of 300 to 500 filaments is preferably used, and a glass fiber fabric made of 350 to 450 filaments is more preferably used. Then, it is possible to obtain an effect that improves the warpage suppression or plate thickness accuracy of the holder for a polished work in response to the thickness reduction of a substrate. Furthermore, as the second fiber base material 221, a glass fiber fabric having a thickness in a range of 100 µm to 250 µm is preferably used, and a glass fiber fabric having a thickness in a range of 180 µm to 200 µm is more preferably used. Then, it is possible to obtain an effect that improves the warpage suppression or plate thickness accuracy of the holder for a polished work in response to the thickness reduction of a substrate. Examples of the above-described glass fiber fabric include glass fiber fabrics having an IPC specification of #1116, #2116, #2117, #1504, #1501, #7628, or #7629. These glass fiber fabrics may have been subjected to an opening process or a flattening process.

A glass component configuring the second fiber base material 221 used in the second resin layer 22 is not particularly limited, and examples thereof include E glass, NE glass, AR glass, C glass, D glass, S glass, T glass, Q glass, and the like. Among the above-described glasses, E glass is preferable from the viewpoint of productivity and economic efficiency.

The holder 1 for a polished work of the invention includes the second fiber base material 221 in the second resin layer 22 preferably in a proportion in a range of 50 mass% to 70 mass%, and more preferably in a proportion in a range of 60 mass% to 70 mass%. Then, it is possible to enhance an effect that improves the warpage suppression or plate thickness accuracy of the holder for a polished work in response to the thickness reduction of a substrate.

As the second resin composition impregnated into the second fiber base material 221, it is possible to use the same composition as the above-described first resin composition. From the viewpoint of warpage or plate thickness accuracy, it becomes possible to bring the linear expansion coefficient of the first resin layer and the linear expansion coefficient of the second resin layer closer by appropriately adjusting the amount of the inorganic filler incorporated, and it becomes possible to improve the warpage suppression or plate thickness accuracy of the holder for a polished work in response to the thickness reduction of a substrate.

Next, a method for manufacturing the laminate plate 2 used in the holder 1 for a polished work of the invention will be described. The first resin composition is dissolved in a solvent, thereby preparing a first resin composition varnish containing approximately 30 mass% to 80 mass%, preferably, 50 mass% to 70 mass% of the solid content. The varnish is impregnated into the first fiber base material 211, and then is dried, thereby obtaining a first prepreg sheet. Similarly, the second resin composition is dissolved in a solvent, thereby preparing a second resin composition varnish containing approximately 30 mass% to 80 mass%, preferably, 50 mass% to 70 mass% of the solid content. The varnish is impregnated into the second fiber base material 221, and then is dried, thereby obtaining a second prepreg sheet. Examples of the solvent include methyl ethyl ketone, toluene/cellosolve, methyl ethyl ketone/toluene, propylene glycol monomethyl ether, dimethyl formamide, cyclohexanone, and the like. After that, the first prepreg sheet is disposed as the outermost layer (surface layer), the second prepreg sheet is disposed as the inside layer (intermediate layer), a predetermined number of the prepreg sheets are laminated, and the laminated prepreg sheets are interposed between mirror plates coated with a release film and are molded through heating and pressurization between hot press boards, whereby the laminate plate 2 can be obtained. The conditions for the molding through heating and pressurization are not particularly limited, and the molding is ordinarily carried out at a temperature in a range of 160°C to 200°C and a pressure in a range of 5 MPa to 50 MPa for approximately 90 minutes to 150 minutes.

In addition, the number of the prepreg sheets used is adjusted depending on the type or polishing conditions of a polished work such as a silicon wafer or a hard disk. In addition, the thicknesses of the holder 1 for a polished work and the laminate plate 2 used in the same are appropriately selected depending on the type or polishing conditions of a polished work using the holder for a polished work and the laminate plate, and are ordinarily in a range of approximately 0.3 mm to 2.0 mm, and preferably in a range of approximately 0.4 mm to 1.0 mm.

### Examples

Next, the invention will be described in more detail using examples, but the invention is not limited to the example by any means.

The following elements were used as various raw materials.

### (1) Epoxy resin

Cresol novolac-type epoxy resin 1: manufactured by DIC Corporation, EPICLON N-690 (softening point: 90°C, epoxy equivalent: 225 g/eq)
Bisphenol A-type epoxy resin 1: manufactured by Mitsubishi Chemical Corporation, EPIKOTE 1001 (softening point: 64°C, epoxy equivalent: 475 g/eq)

### (2) Curing agent

Phenol novolac resin 1: manufactured by Sumitomo Bakelite Co., Ltd., PR-51470 (softening point: 107°C, hydroxyl group equivalent: 105 g/eq)
Dicyandiamide: manufactured by Nippon Carbide Industries Co., Inc., DDA

### (3) Curing accelerator

2-Phenyl-4-methyl imidazole (2P4MZ): manufactured by Shikoku Chemicals Corporation

### (4) Glass fiber fabric

Glass fiber fabric 1 (GC1): manufactured by Unitika Glass Fiber Co., Ltd., E10T (made of E glass, weight per area: 106 g/m², filament diameter: approximately 5 µm, number of filaments: approximately 400, thickness: 90 µm)
Glass fiber fabric 2 (GC2): manufactured by Unitika Glass Fiber Co., Ltd., E18S (made of E glass, weight per area: 210 g/m², filament diameter: approximately 9 µm, number of filaments: approximately 400, thickness: 180 µm)
Glass fiber fabric 3 (GC3): manufactured by Unitika Glass Fiber Co., Ltd., E06B (made of E glass, weight per area: 48 g/m², filament diameter: approximately 5 µm, number of filaments: approximately 200, thickness: 55 µm)
Aramid fiber fabric 4 (AC4): manufactured by Asahi Kasei E-materials Corporation, aramid fiber fabric (made of TECHNORA, weight per area: 60.6 g/m², filament diameter: 18 µm, number of filaments: 65, thickness: 95 µm)

### Example 1

### Preparation of resin composition varnishes for the first and second fiber base materials

Methyl ethyl ketone was added as a solvent to a mixture of 50 parts by mass of the cresol novolac-type epoxy resin 1, 20 parts by mass of the bisphenol A-type epoxy resin 1, 30 parts by mass of the phenol novolac resin 1, and 0.1 parts by mass of 2P4MZ, thereby preparing a varnish for a resin composition A containing 55 mass% of the solid content.

### Production of first prepreg sheet

The varnish for the resin composition A was impregnated into the glass fiber fabric 1, and then the glass fiber fabric was dried, thereby producing a prepreg sheet 1A40 containing 40 mass% of the resin composition and 60 mass% of the glass fiber fabric (meaning GC1/the resin composition A/40 mass% of the resin composition).

### Production of second prepreg sheet

The varnish for the resin composition A was impregnated into the glass fiber fabric 2, and then the glass fiber fabric was dried, thereby producing a prepreg sheet 2A41 containing 41 mass% of the resin composition and 59 mass% of the glass fiber fabric (meaning GC2/the resin composition A/41 mass% of the resin composition).

### Production of laminate plate used for holder for polished work

Two prepreg sheets 1A40 were disposed as the outermost layer (surface layer), three prepreg sheets 2A41 were disposed as the inside layer (intermediate layer), the sheets were laminated, and the laminated sheets were interposed between mirror plates coated with a release film and were molded through heating and pressurization between hot press boards, thereby producing a laminate plate having a height of 1250 mm, a width of 1250 mm, and a thickness of 0.8 mm. The molding through heating and pressurization was carried out at a heating temperature of 180°C and a pressurization pressure of 40 MPa for a pressurization time of 120 minutes.

### Production of holder for polished work

From the obtained laminate plate used for a holder for a polished work, a holder for a polished work was produced using a router machine in a manner in which teeth for a gear were manufactured on the outer shape so that the outer shape dimension of a line connecting protrusion sections of the teeth of a gear reached φ515 mm, and the inner diameter dimension of a hole holding a polished work reached φ200 mm.

### Examples 2 to 14, and Comparative Examples 1 and 4

Components were incorporated at compositions described in Table 1, thereby preparing varnishes for the resin compositions A to G respectively as the varnishes for the resin compositions for the first and second fiber base materials. After that, the varnishes for the resin compositions were impregnated into GC1 to GC3 as the first fiber base materials at the combinations described in Table 1, and the resultants were dried so as to obtain the GC amounts described in Table 1, thereby producing, as prepreg sheets disposed as the outermost layer, prepreg sheets 1B40 (meaning GC1/the resin composition B/40 mass% of the resin composition; hereinafter, only the resin composition type differs), 1C40, 1D40, 1E40, 1F40, 1G40, 1A50 (meaning GC1/the resin composition A/50 mass% of the resin composition; hereinafter, only the resin composition type differs), 1B50, 1C50, 2A41 (meaning GC2/the resin composition A/41 mass% of the resin composition), 3A74 (meaning GC3/the resin composition A/74 mass% of the resin composition; hereinafter, only the resin composition type differs), 3B74, 3C74, 3D74, and 3E74. In addition, the varnishes for the resin compositions were impregnated into GC2 as the second fiber base materials at the combinations described in Table 1, and the resultants were dried so as to obtain the GC amounts described in Table 1. As prepreg sheets disposed as the inside layer, prepreg sheets 2A41 (meaning GC2/the resin composition A/41 mass% of the resin composition; hereinafter, only the resin composition type differs), 2B41, 2C41, 2D41, 2E41, 2F41, 2G41, 2A35 (meaning GC2/the resin composition A/35 mass% of the resin composition; hereinafter, only the resin composition type differs), 2B35, 2C35, 2D35, and 2E35 were produced, and the prepreg sheets were laminated and disposed according to the number of the sheets described in Table 1. Except for the above-described fact, the laminate plates for the holder for a polished work and the holder for a polished work were produced in the same manner as Example 1.

### Comparative Examples 2 and 3

Components were incorporated at compositions described in Table 1, thereby preparing varnishes for the resin compositions A and F respectively as the varnishes for the resin compositions for the first and second fiber base materials. After that, the varnishes for the resin compositions A and F were impregnated into the aramid fiber fabric AC4 as the first fiber base material, and the aramid fiber fabric was dried. As prepreg sheets disposed as the outermost layer, prepreg sheets 4A55 (meaning AC4/the resin composition A/55 mass% of the resin composition; hereinafter, only the resin composition type differs) and 4F40 were produced. In addition, the varnishes for the resin compositions A and F were impregnated into GC2 as the second fiber base material, and the resultants were dried, thereby producing, as prepreg sheets disposed as the inside layer, prepreg sheets 2A41 (meaning GC2/the resin composition A/41 mass% of the resin composition; hereinafter, only the resin composition type differs) and 2F41. Except for the above-described fact, the laminate plates for the holder for a polished work and the holder for a polished work were produced in the same manner as Example 1.

### Evaluation methods

The following evaluation was carried out on the laminate plates for the holder for a polished work and the holder for a polished work produced in Examples 1 to 14 and Comparative Examples 1 to 4, and the results are described in Table 1.

### Glass transition temperature

A specimen having a width of 10 mm, a thickness of 0.8 mm, and a length of 50 mm was cut out from the obtained laminate plate used for the holder for a polished work, and the dynamic viscoelasticity was measured by applying a strain having a frequency of 1 Hz while increasing the temperature at a rate of 5°C/minute using a DMA apparatus (DMA2980 manufactured by TA Instruments). A temperature at which tanδ showed a maximum value was obtained as the glass transition temperature.

### Hardness (Barcol hardness)

The Barcol hardness at 25°C (hardness meter: GYZJ934-1) of the obtained laminate plate used for the holder for a polished work was measured on the basis of JIS K 6711 "Testing methods for thermosetting plastics".

### Abrasion resistance

A laminate plate used for a holder for a polished work obtained by opening a 200 mmφ hole in the vicinity of the center of the obtained disc-like 515 mmφ laminate plate used for a holder for a polished work was polished using a both-surface polishing machine. A 0.7 mm-thick silicon wafer was put into the 200 mmφ hole section, which was present in the obtained holder for a polished work, and polishing was carried out for 180 minutes at a surface pressure of 9.8 MPa, a carrier rotation rate of 5 rpm, and a vertical polishing plate rotation rate of 20 rpm. When the abrasion amount was 12 µm or less, the plate was evaluated to be O; however, when the abrasion amount exceeded 12 µm, the plate was evaluated to be X.

### Warpage

The obtained holder for a polished work was horizontally placed on a flat board, and the uplift value of the material was measured. When the uplift value was 5 mm or less, the plate was evaluated to be O; however, when the uplift value exceeds 5 mm, the plate was evaluated to be X.

### Flatness

The surface unevenness difference R_{MAX}-R_{MIN} of the obtained holder for a polished work was obtained using a contact-type surface roughness meter. The material having a R_{MAX}-R_{MIN} of 4 µm or less was evaluated to be A, the material having a R_{MAX}-R_{MIN} in a range of more than 4 µm to 6 µm was evaluated to be B, and the material having a R_{MAX}-R_{MIN} of more than 6 µm was evaluated to be C.

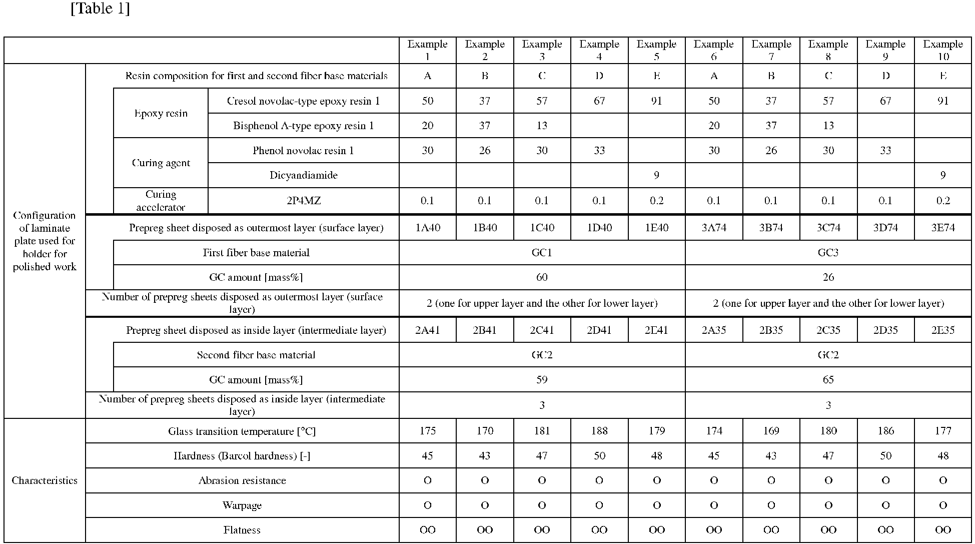

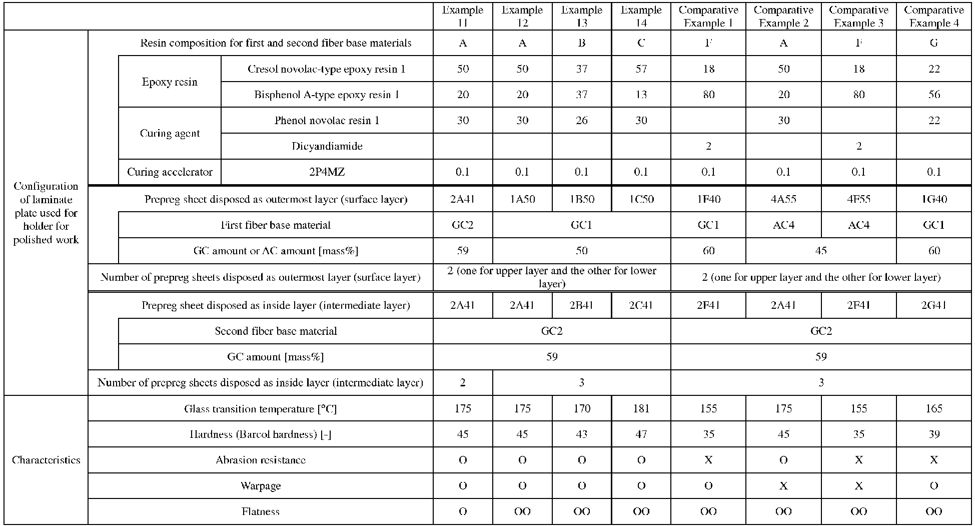

In all of Examples 1 to 14 in which the first resin layer produced by impregnating the first resin composition into the first fiber base material, and heating and pressurizing the first fiber base material was provided as the outermost layer, the glass fiber base material was used as the first fiber base material, and the structure derived from a resin having a novolac skeleton was included in a proportion of 50 mass% or more in the first resin layer, the glass transition temperature (thermal resistance) and the Barcol hardness (surface hardness) were high, and the abrasion resistance, warpage suppression, and the flatness were excellent. Particularly, in Examples 1 to 10 and 12 to 14 in which the glass fiber fabric having a weight per area in a range of 30 g/m² to 150 g/m² was used as the first fiber base material, the flatness was particularly excellent.

On the other hand, in Comparative Examples 2 and 3 in which the aramid fiber fabric was used as the first fiber base material instead of the glass fiber base material, the warpage suppression was poor. In addition, in Comparative Examples 1, 3, and 4 in which the proportion of the structure derived from a resin having a novolac skeleton in the first resin layer failed to satisfy 50 mass%, the glass transition temperature (thermal resistance) and the Barcol hardness (surface hardness) were low, and the abrasion resistance was poor.

### Industrial Applicability

According to the invention, it is possible to provide a holder for a polished work in which the warpage suppression or plate thickness accuracy of the holder for a polished work is improved in response to the thickness reduction of a substrate, the generation of scratches in a polished work is suppressed so as to improve the abrasion resistance, and furthermore, economic advantages are provided, and a laminate plate using the same. Therefore, the invention can be preferably used for a holder for a polished work and a laminate plate using the same. Therefore, the invention is extremely useful to industry.

### Reference Signs List

- 1: HOLDER FOR POLISHED WORK
- 11: CIRCULAR HOLE
- 12: TEETH OF GEAR
- 2: LAMINATE PLATE USED FOR HOLDER FOR POLISHED WORK
- 21: FIRST RESIN LAYER
- 211: FIRST FIBER BASE MATERIAL
- 22: SECOND RESIN LAYER
- 221: SECOND FIBER BASE MATERIAL

## Claims

1. A holder for a polished work, comprising:
a first resin layer produced by impregnating a first resin composition into a first fiber base material, and heating and pressurizing the first fiber base material as an outermost layer,
wherein the first fiber base material is a glass fiber base material, and
a structure derived from a resin having a novolac skeleton is included in a proportion of 50 mass% or more in the first resin layer excluding the first fiber base material.

2. The holder for a polished work according to Claim 1,
wherein the first fiber base material is included in a proportion in a range of 25 mass% to 60 mass% in the first resin layer.

3. The holder for a polished work according to Claim 1 or 2,
wherein the first fiber base material is made of a glass fiber fabric having a weight per area in a range of 30 g/m² to 150 g/m².

4. The holder for a polished work according to any one of Claims 1 to 3,
wherein the first resin composition contains one or more resins selected from a novolac-type epoxy resin and a novolac-type phenol resin.

5. The holder for a polished work according to any one of Claims 1 to 4,
wherein the first resin composition contains the novolac-type epoxy resin in a proportion in a range of 40 parts by mass to 80 parts by mass in 100 parts by mass of the composition.

6. The holder for a polished work according to any one of Claims 1 to 5,
wherein the first resin composition contains the novolac-type phenol resin in a proportion in a range of 20 parts by mass to 40 parts by mass in 100 parts by mass of the composition.

7. The holder for a polished work according to any one of Claims 1 to 6,
wherein the first resin composition further contains a bisphenol A-type epoxy resin in a proportion in a range of 5 parts by mass to 40 parts by mass in 100 parts by mass of the composition.

8. The holder for a polished work according to any one of Claims 1 to 7, further comprising:
one or more second resin layers produced by impregnating a second resin composition into a second fiber base material, and heating and pressurizing the second fiber base material as an inside layer,
wherein the second fiber base material is a glass fiber base material.

9. The holder for a polished work according to Claim 8,
wherein the second fiber base material is made of a glass fiber fabric having a weight per area in a range of 100 g/m² to 220 g/m².

10. A laminate plate used for the holder for a polished work according to any one of Claims 1 to 9.
